# EUROPÄISCHE PATENTANMELDUNG

(11) **EP 1 924 124 A2**
(43) Veröffentlichungstag der Anmeldung: **21.05.2008**
(21) Anmeldenummer: 07117748.9
(22) Anmeldetag: 02.10.2007
(51) Int. Cl.: H04R 25/00

(54) **Verfahren zur Schätzung eines Störfelds für eine Spule**

(30) Priorität: 16.10.2006 DE 102006049471
(71) Anmelder: Siemens Audiologische Technik GmbH, 91058 Erlangen (DE)
(72) Erfinder: Nikles, Peter, 91054 Erlangen (DE); Radick, Marius, 90409 Nürnberg (DE)
(74) Vertreter: Maier, Daniel Oliver

(57) **Zusammenfassung**

Eine optimale Position einer Hörspule in einer Hörvorrichtung und insbesondere in einem Hörgerät soll möglichst rasch und einfach gefunden werden. Hierzu wird ein Verfahren zur Schätzung eines Störfelds für eine reale Spule durch Bereitstellen einer simulierten Feldverteilung des Störfelds (S1, S2), Berechnen je einer Störfeldgröße für mehrere Spulensegmente einer die reale Spule repräsentierenden virtuellen Spule zu einem vorgegebenen Ort und einer vorgegebenen Orientierung der virtuellen Spule in dem Störfeld und Berechnen einer Gesamtstörfeldgröße der virtuellen Spule zu dem vorgegeben Ort und der vorgegebenen Orientierung (S3), indem jede Störfeldgröße der mehreren Spulensegmente jeweils mit einem individuellen, veränderbaren Gewicht beaufschlagt wird, angegeben. Anschließend wird eine der Gesamtstörfeldgröße entsprechende Feldgröße mit der realen Spule an dem vorgegeben Ort mit der vorgegebenen Orientierung in dem Störfeld gemessen (S4). Schließlich werden die individuellen Gewichte in Abhängigkeit eines Vergleichs zwischen der gemessenen Feldgröße und der berechneten Gesamtstörfeldgröße angepasst (S5, S6). Damit ist eine rasche, kalibrierte Schätzung beziehungsweise Berechnung des Einflusses eines Störfelds auf eine Spule möglich.

## Beschreibung

Die vorliegende Erfindung betrifft ein Verfahren zur Schätzung eines Störfelds für eine reale Spule einer Hörvorrichtung. Unter dem Begriff Hörvorrichtung wird hier insbesondere ein Hörgerät, ein Headset oder ein Kopfhörer verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Indem-Ohr-Hörgeräte (IdO) und Concha-Hörgeräte bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

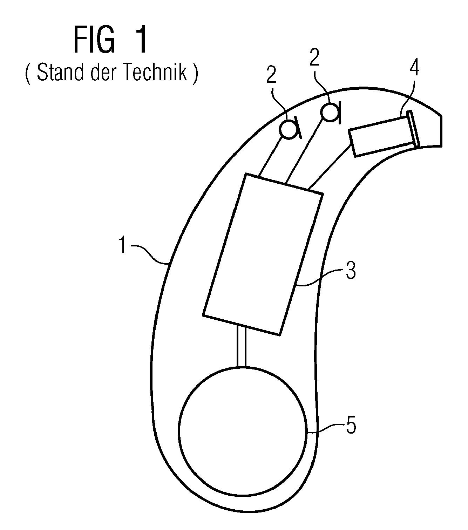

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Bei der Anwendung induktiver Übertragungskomponenten in Hörsystemen ist es notwendig, den Einfluss interner, durch das System selbst hervorgerufener Störungen gering zu halten. Die induktive Übertragungskomponente kann nur externe Signale empfangen, deren Signalstärke über die der internen Störsignale hinausgeht. Eine typische Quelle solcher interner Störungen ist der als magnetischer Wandler ausgeführte Hörer, der starke induktive Signale abstrahlt. Weitere Störquellen sind die Zuleitungen zu dem Hörer, aber auch die verschiedenen Energiezuführungen zur Hörgeräteelektronik, die durch den Stromfluss als induktive Antennen angesehen werden müssen. Am Ort einer Antennenspule eines drahtlosen Übertragungssystems, welche den induktiven oder auch den typischen RF-Bereich nutzt, empfängt man in der Regel die Überlagerung zahlreicher Störungen.

Bislang wurde ein Faceplate eines IdO-Hörgeräts in der Regel als Modul mit integrierter Antennenspule gefertigt. Dadurch ist die Position der Spule bis auf geringe Abweichungen vorgegeben und mehr oder weniger große Störungen müssen in Kauf genommen werden. Die Position der Spule muss daher durch aufwendige Messungen bestimmt und optimiert werden. Bei einer so genannten "semimodularen" Bauweise ist die Spule nicht direkt auf das Faceplate montiert und kann individuell in der Hörgeräteschale platziert werden. Auf diese Weise lassen sich die Störungen reduzieren, aber die aufwendigen Messungen zur Bestimmung der individuellen Position der Spule bleiben.

Aufgrund ihrer Größe und räumlichen Ausdehnung gibt es nicht viele Möglichkeiten, eine Antennenspule im Hörgerätegehäuse zu platzieren. Diese physischen Restriktionen können beispielsweise mit Hilfe von Kollisionswolken ermittelt und bedacht werden. Unberücksichtigt dabei bleibt jedoch der Einfluss von Störfeldern auf die Antennenspule.

Aus der Druckschrift DE 42 26 413 A1 ist ein Verfahren zur Vermessung eines in einem lebenden Organ erzeugten elektrischen Stroms bekannt. Dabei werden eine Mehrzahl von Aufnehmerspulen zur Messung von Magnetfeldstärken angewendet, die an Erfassungspunkten positioniert werden. An interpolierten oder extrapolierten Erfassungspunkten werden daraus die dortigen Magnetfeldstärken abgeschätzt.

Die Aufgabe der vorliegenden Erfindung besteht darin, ein Störfeld, das in einer Spule einer Hörvorrichtung entsprechende Störungen hervorruft, vor dem Festlegen einer endgültigen Platzierung der Spule abschätzen beziehungsweise berechnen zu können.

Erfindungsgemäß wird diese Aufgabe gelöst durch ein Verfahren zur Schätzung eines Störfelds für eine reale Spule einer Hörvorrichtung durch Bereitstellen einer simulierten Feldverteilung des Störfelds, Berechnen je einer Störfeldgröße für mehrere Spulensegmente einer die reale Spule repräsentierenden virtuellen Spule zu einem vorgegebenen Ort und einer vorgegebenen Orientierung der virtuellen Spule in dem Störfeld, Berechnen einer Gesamtstörfeldgröße der virtuellen Spule zu dem vorgegebenen Ort und der vorgegebenen Orientierung, wobei jede Störfeldgröße der mehreren Spulensegmente jeweils mit einem individuellen, veränderbaren Gewicht beaufschlagt wird, Messen einer der Gesamtstörfeldgröße entsprechenden Feldgröße mit der realen Spule an dem vorgegebenen Ort mit der vorgegebenen Orientierung in dem Störfeld, Anpassen der individuellen Gewichte in Abhängigkeit eines Vergleichs zwischen der gemessenen Feldgröße und der berechneten Gesamtstörfeldgröße und Berechnen der Gesamtstörfeldgröße für einen anderen Ort oder eine andere Orientierung der virtuellen Spule (10) als Schätzung des Störfelds dort auf der Grundlage der angepassten, individuellen Gewichte.

In vorteilhafter Weise kann die Schätzung des Störfelds für einen bestimmten Ort und eine bestimmte Orientierung der Spule in der Hörvorrichtung auf einfache Art durchgeführt werden. Eine entsprechende, vollständige Simulation inklusive der Spule würde bei der Komplexität einer Spule (sehr hoher Segmentierungsaufwand in der herkömmlichen Simulationssoftware) eine sehr lange Rechenzeit bedeuten. Um die Schätzung qualitativ hochwertig zu gestalten, erfolgt eine Kalibration mit Hilfe von tatsächlich durchgeführten Messungen. Je nach gewünschter Genauigkeit können entsprechend viele Messpunkte für die Kalibration herangezogen werden.

Entsprechend einer speziellen Ausführungsform wird die Feldgröße indirekt durch eine Spannung an der realen Spule gemessen und für das Anpassen der individuellen Gewichte entweder die Gesamtstörfeldgröße in eine virtuelle Spannung oder die gemessene Spannung in eine entsprechende Feldgröße umgerechnet. Hierdurch lässt sich einfach die an der realen Spule anliegende und durch das Störfeld hervorgerufene Spannung abgreifen und für die Kalibration heranziehen.

Weiterhin ist es vorteilhaft, wenn eine dreidimensionale, simulierte Feldverteilung des Störfelds bereitgestellt wird und die Gesamtstörfeldgröße durch schichtweises Berechnen von entsprechenden 2D-Komponenten in der virtuellen Spule ermittelt wird. Auf diese Weise lässt sich die Komplexität der Störfeldberechnung in der Spule deutlich reduzieren.

Für die Schätzung des Störfelds kann die virtuelle Spule beispielsweise in zwei, drei oder vier Segmente unterteilt werden. Selbstverständlich ist es auch möglich, die Spule in weitere Segmente zu unterteilen, falls die Genauigkeit der Kalibration dies erfordert.

Das erfindungsgemäße Verfahren lässt sich für mehrere Orte und/oder Orientierungen der virtuellen und realen Spule in dem Störfeld durchführen. Am Ende dieser Schätzungen beziehungsweise Berechnungen kann dann ein optimaler Ort für die Spule in der Hörvorrichtung bestimmt beziehungsweise vorhergesagt werden.

Besonders vorteilhaft kann das erfindungsgemäße Verfahren zum Schätzen eines Störfelds für die Verhältnisse in einem Hörgerätegehäuse eingesetzt werden. Somit lässt sich die Orientierung und der Ort einer Antennenspule eines Hörgeräts optimieren.

Die vorliegende Erfindung ist anhand der beigefügten Zeichnungen näher erläutert, in denen zeigen:
- FIG 1: eine schematische Ansicht der Hauptkomponenten eines Hörgeräts;
- FIG 2: eine zweidimensionale Ansicht eines Störfelds mit segmentierter, virtueller Spule;
- FIG 3: ein Flussdiagramm zu einer Ausführungsform eines erfindungsgemäßen Verfahrens zur Kalibrierung eines Berechnungsalgorithmus und
- FIG 4: ein Ablaufdiagramm eines beispielhaften Berechnungsalgorithmus.

Die nachfolgend näher geschilderten Ausführungsbeispiele stellen bevorzugte Ausführungsformen der vorliegenden Erfindung dar.

Das Störfeld, das auf eine Spule wirkt, ist grundsätzlich dreidimensional ausgebildet. Um jedoch die Komplexität der Berechnung des Störfelds so gering wie möglich zu halten, wird ein 2D-Berechnungsansatz gewählt. Hierbei wird der dreidimensionale Datensatz einer Feldsimulation in Schnittebenen unterteilt. Es wird weiterhin die Annahme zugrunde gelegt, dass der magnetische Fluss zum größten Teil nahe des Kernmittelpunkts der Spule geführt wird. Das Volumen der Spule wird durch die maximale Fläche der Spule innerhalb der jeweiligen Schnittebene repräsentiert.

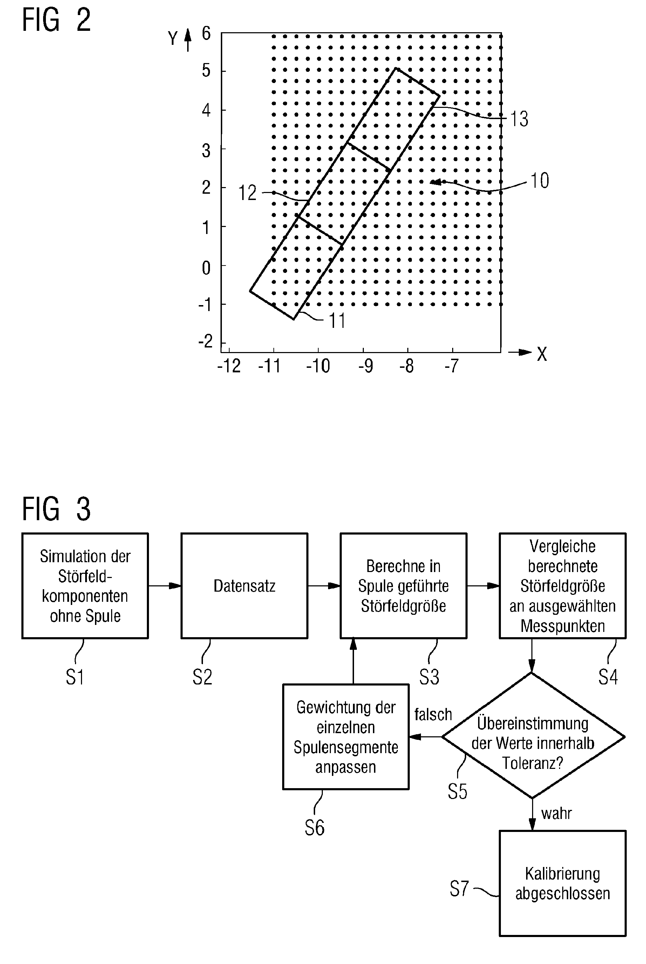

In FIG 2 ist eine Schnittebene eines Störfelds schematisch dargestellt. Die Punkte repräsentieren jeweils einen Datenpunkt (Feldkomponente, Phase) der Simulation des Störfelds. Die Spule in dem Störfeld ist durch ein Rechteck 10 dargestellt. Sie ist hier in drei gleichgroße Segmente 11, 12 und 13 unterteilt. Mit dieser Segmentierung lässt sich das Einkoppelverhalten der virtuellen Spule genauer beschreiben, denn die einzelnen Segmente 11, 12, 13 können gewichtet werden, um die Berechnung anhand von einzelnen Messungen zu kalibrieren. Abschließend wird das Ergebnis normiert.

Im konkreten Beispiel von FIG 2 wurde die virtuelle Spule an dem Ort x = -11 und y = -1 bei einem Neigungswinkel von 30 Grad platziert. Damit ist die Lage der virtuellen Spule in dem Störfeld eindeutig bestimmt. In einem nächsten Schritt werden dann die Datenpunkte die innerhalb eines bestimmten Segments 11, 12 oder 13 liegen, identifiziert. Die einzelnen Punkte bestimmen dann den Beitrag jedes Segments zu der gesamten in der Spule hervorgerufenen Störung. Bei genügend kleiner Rasterung des Simulationsfeldbilds kann die in die Spule eingekoppelte Feldstärke ausreichend genau bestimmt werden.

Aus einem einzigen Simulationsdatensatz können die in der Spule geführten Feldstärken für sämtliche Spulenwinkel und variable Spulengeometrien (Länge, Durchmesser) rasch berechnet werden. Auf diese Weise können "Kollisionswolken" ermittelt werden, die sich auf elektromagnetische Störungen beziehungsweise Wechselwirkungen zwischen den einzelnen Komponenten beispielsweise eines Id0 beziehen. Gegebenenfalls können die Kollisionswolken in Echtzeit berechnet werden. Hierdurch ist es möglich, interaktiv Verbesserungen in der Verkabelung oder der Konstruktion nicht nur von Hörgeräten zu visualisieren.

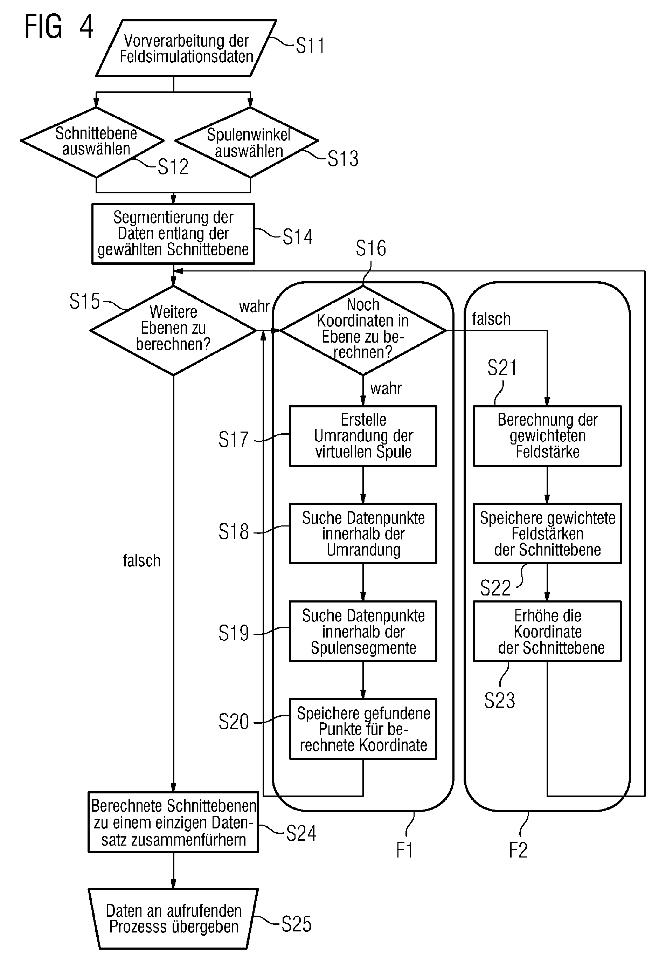

Das Kalibrieren des Berechnungsalgorithmus ist in FIG 3 näher dargestellt. Demnach werden zunächst entsprechend Schritt S1 die Störfeldkomponenten ohne Spule simuliert. Daraus wird entsprechend Schritt 2 ein Datensatz für die Feldverteilung gewonnen. Aus diesem Datensatz wird dann, wie dies im Zusammenhang mit FIG 2 angedeutet wurde, die in die Spule geführte Störfeldgröße gemäß Schritt S3 berechnet. Die genaue Durchführung der Berechnung wird unten zusammen mit FIG 4 näher erläutert.

Die Kalibration erfordert, wie oben erwähnt, das Vermessen des Störfelds beziehungsweise seiner Wirkung mit einer realen Spule. Dazu werden Messungen an ausgewählten Messpunkten durchgeführt. Gemäß Schritt S4 werden daraufhin die in Schritt S3 für den jeweiligen Messpunkt berechnete Störfeldgröße mit der Messung verglichen. Wenn die Werte aus Berechnung beziehungsweise Schätzung und Messung nicht und auch nicht innerhalb einer vorbestimmten Toleranz, übereinstimmen, was in Schritt S5 überprüft wird, so werden gemäß Schritt S6 die Gewichte der einzelnen Spulensegmente angepasst. Die neuen Gewichte werden für die Berechnung der Störfeldgröße in der virtuellen Spule in Schritt S3 verwendet.

Die Kalibrierungsschleife S3 bis S6 wird so lange durchlaufen, bis in Schritt S5 festgestellt wird, dass die berechneten und gemessenen Werte innerhalb der geforderten Toleranz sind. Die Kalibrierungsschleife wird daraufhin verlassen und die Kalibrierung ist gemäß Schritt S7 abgeschlossen.

In FIG 4 ist der Schritt von S3, d. h. die Berechnung der Störfeldgröße in einem Ablaufdiagramm schematisch dargestellt. In Schritt S11 erfolgt zunächst eine Vorverarbeitung der von Schritt S2 erhaltenen Feldsimulationsdaten. Nach der Vorverarbeitung wird für die virtuelle Spule eine Schnittebene S12 und ein Spulenwinkel S13 ausgewählt. Anschließend erfolgt gemäß Schritt S14 eine Segmentierung der Daten entlang der gewählten Schnittebene, wie sie beispielsweise in FIG 2 zu erkennen ist. Die virtuelle Spule wird also beispielsweise in der aktuellen Ebene in drei Segmente unterteilt. Nun wird für alle Ebenen der dreidimensionalen Feldverteilung jeweils eine Schleife durchlaufen (S15). In dieser Schleife wird zunächst innerhalb einer Unterschleife geprüft, ob beispielsweise für eine Kollisionswolke noch weitere Koordinaten in der Ebene zu berechnen sind (S16). In FIG 4 ist diese Unterschleife, mit deren Hilfe die relevanten Datenpunkte ermittelt werden, mit F1 bezeichnet. Dabei wird in einem anfänglichen Schritt S17 eine Umrandung der virtuellen Spule erstellt (vergleiche virtuelle Spule 10 in FIG 2). Entsprechend Schritt S18 werden Datenpunkte innerhalb der Umrandung gesucht. Dabei wird gemäß Schritt S19 berücksichtigt, innerhalb welcher Spulensegmente sich die Datenpunkte befinden. Die ermittelten Punkte werden für die berechnete Koordinate in Schritt S20 gespeichert. Die Unterschleife, d. h. die Schrittfolge S16 bis S20, wird so lange wiederholt, so lange noch Koordinaten in der Ebene zu berechnen sind.

Ist die Ebene vollständig berechnet, so folgt ein Funktionenblock F2, in dem die gewichteten Feldstärken für jedes Spulensegment ebenenweise berechnet werden. Dazu wird in Schritt S21 die gewichtete Feldstärke für die jeweilige Schnittebene berechnet. Im anschließenden Schritt S22 wird die gewichtete Feldstärke der Schnittebene gespeichert. Sodann wird die Koordinate der Schnittebene erhöht und in Schritt S15 erneut überprüft, ob weitere Ebenen zu berechnen sind.

Wenn sämtliche Ebenen berechnet sind, werden in Schritt S24 die berechneten Schnittebenen zu einem einzigen Datensatz zusammengeführt. Diese Daten werden schließlich an einen aufrufenden Prozess gemäß Schritt S25 übergeben. Dieser aufrufende Prozess ist beispielsweise der Schritt S4 in FIG 3.

## Patentansprüche

1. Verfahren zur Schätzung eines Störfelds für eine reale Spule einer Hörvorrichtung durch
- Bereitstellen einer simulierten Feldverteilung des Störfelds (S1),
- Berechnen je einer Störfeldgröße für mehrere Spulensegmente (11, 12, 13) einer die reale Spule repräsentierenden virtuellen Spule (10) zu einem vorgegebenen Ort und einer vorgegebenen Orientierung der virtuellen Spule in dem Störfeld,
- Berechnen einer Gesamtstörfeldgröße (S3) der virtuellen Spule (10) zu dem vorgegebenen Ort und der vorgegebenen Orientierung, wobei jede Störfeldgröße der mehreren Spulensegmente (11, 12, 13) jeweils mit einem individuellen, veränderbaren Gewicht beaufschlagt (S21) wird,
- Messen einer der Gesamtstörfeldgröße entsprechenden Feldgröße mit der realen Spule an dem vorgegebenen Ort mit der vorgegebenen Orientierung in dem Störfeld,
- Anpassen der individuellen Gewichte (S5, S6) in Abhängigkeit eines Vergleichs (S4) zwischen der gemessenen Feldgröße und der berechneten Gesamtstörfeldgröße und
- Berechnen der Gesamtstörfeldgröße für einen anderen Ort oder eine andere Orientierung der virtuellen Spule (10) als Schätzung des Störfelds dort auf der Grundlage der angepassten, individuellen Gewichte.

2. Verfahren nach Anspruch 1, wobei die Feldgröße indirekt durch eine Spannung an der realen Spule gemessen wird und für das Anpassen (S4) der individuellen Gewichte entweder die Gesamtstörfeldgröße in eine virtuelle Spannung oder die gemessene Spannung in eine entsprechende Feldgröße umgerechnet wird.

3. Verfahren nach Anspruch 1 oder 2, wobei eine dreidimensionale, simulierte Feldverteilung des Störfelds bereitgestellt wird und die Gesamtstörfeldgröße durch schichtweises Berechnen von entsprechenden 2D-Komponenten in der virtuellen Spule (10) ermittelt wird.

4. Verfahren nach einem der vorhergehenden Ansprüche, wobei die virtuelle Spule (10) in zwei, drei oder vier Segmente (11, 12, 13) unterteilt wird.

5. Verfahren nach einem der vorhergehenden Ansprüche, das für mehrere Orte und/oder Orientierungen der virtuellen und realen Spule in dem Störfeld durchgeführt wird (S16).

6. Verfahren nach einem der vorhergehenden Ansprüche, wobei das Störfeld in einem Hörgerätegehäuse (1) geschätzt wird.
